# EUROPÄISCHE PATENTSCHRIFT

(11) **EP 0 905 707 B1**
(45) Veröffentlichungstag und Bekanntmachung des Hinweises auf die Patenterteilung: **21.04.2004**
(21) Anmeldenummer: 98117136.6
(22) Anmeldetag: 10.09.1998
(51) Int. Cl.: G11C 15/04

(54) **Assoziativspeicher und Verfahren zu dessen Betrieb**
Content addressed memory and method therefor
Mémoire associative et méthode de fonctionnement

(30) Priorität: 29.09.1997 DE 19742961
(43) Veröffentlichungstag der Anmeldung: 31.03.1999
(73) Patentinhaber: Infineon Technologies AG, 81669 München (DE)
(72) Erfinder: Jung, Stefan, 80469 München (DE); Thewes, Roland, Dr., 82194 Gröbenzell (DE); Weber, Werner, Dr., 80637 München (DE); Luck, Andreas, 81737 München (DE)
(74) Vertreter: Patentanwaltskanzlei WILHELM & BECK

(56) Entgegenhaltungen:
- US-A- 5 353 382
- GOSER K: "VLSI TECHNOLOGIES FOR ARTIFICIAL NEURAL NETWORKS" IEEE MICRO, Bd. 9, Nr. 6, 1. Dezember 1989, Seiten 28-44, XP000086575

## Beschreibung

Die Erfindung betrifft einen neuronalen Assoziativspeicher, der in bestimmten schnellen datenverarbeitenden Systemen gegenüber konventionellen vergleichbaren Systemen aufgrund der hochgradigen Parallelverarbeitung große Vorteile besitzt. Insbesondere bei der schnellen Zuordnung von Daten als Antwort auf Sensordaten, z. B. in der Bildverarbeitung oder in der Datenverarbeitung in intelligenten Sensoren, werden entsprechende VLSI-Schaltungen mit einem geringen Flächen- und Energieverbrauch benötigt.

Assoziative Speicher bestehen wie auch ein konventioneller Speicher aus einer matrixförmig angeordneten Menge von Speicherzellen, die jedoch ein gewisses zusätzliches Maß an Funktionalität besitzen. Bei bisherigen lernfähigen neurönalen Assoziativspeichern stellen die Speicherzellen stets eine Art Prozessorelement oder Automat dar, der jeweils aus aus einem lokalen Speicher und einer lokalen Ablaufsteuerung besteht.

Aus dem Artikel von Palm mit dem Titel On Associative Memory" in Biological Cybernetics 36, 1980, Seiten 19-31 ist das Prinzip der sogenannten 'Assoziativen Matrix' bekannt. Es handelt sich dabei um eine binäre Speichermatrix, in welche die ebenfalls binären Eingangsvektoren X reihenweise und die Ausgangsvektoren Y spaltenweise ein- bzw. ausgelesen werden. Das assoziative Speichern geschieht dabei durch eine vereinfachte Form der sogenannten Hebb'schen Lernregel, die beim Anlegen eines zu assoziierenden Musterpaares X/Y an die Matrix lokal bei jedem Matrixelement mᵢⱼ entscheidet, auf welche Weise dessen Zustand zu verändern ist. Im speziellen sieht dies so aus, daß die Speichermatrix zunächst im initialisierten Zustand ganz mit 'logischen Nullen' besetzt ist. Während des Lernvorgangs gilt dann für jede Speicherzelle mᵢⱼ, daß sich deren Zustand genau dann von 'logisch 0' auf 'logisch 1' ändert, wenn gilt Xᵢ = Yⱼ = 'logisch 1'. Wenn in der betreffenden Speicherzelle bereits eine 'logische 1' geschrieben wurde, so soll dieser Zustand beibehalten werden. Beim Auslesen eines eingespeicherten Datenwortes wird der betreffende Eingangsvektor X der Matrix dargeboten und die Ausgangsgröße Y' wird gebildet, indem spaltenweise die Aktivitäten der Speicherzellen aufaddiert werden und auf diese Summe eine Schwellwertentscheidung angewendet wird. Dabei gilt eine Speicherzelle als aktiv, falls xᵢ = mᵢⱼ = '1'.

Aus dem Proceedings zur IEEE-Konferenz MicroNeuro '96, Seiten 68-79 sind Prinzipien, Vorteile und Grenzen von analogen Rechenfeldern bekannt.

Die der Erfindung zugrundeliegende Aufgabe liegt nun darin, einen Assoziativspeicher und ein Verfahren zu dessen Betrieb anzugeben, bei dem eine Zelle des Assoziativspeichers möglichst wenig Bauelemente aufweist und eine Integrationsdichte erreichbar ist, die der von konventionellen Festwertspeichern (EEPROM, EPROM) nahekommt, und der eine möglichst geringe Verlustleistung aufweist.

Diese Aufgabe wird hinsichtlich des Assoziativspeichers durch die Merkmale des Patentanspruchs 1 und hinsichtlich des Verfahrens durch die Merkmale des Patentanspruchs 3 gelöst. Die Merkmale des Patentanspruchs 2 betreffen eine vorteilhafte Weiterbildung der Erfindung.

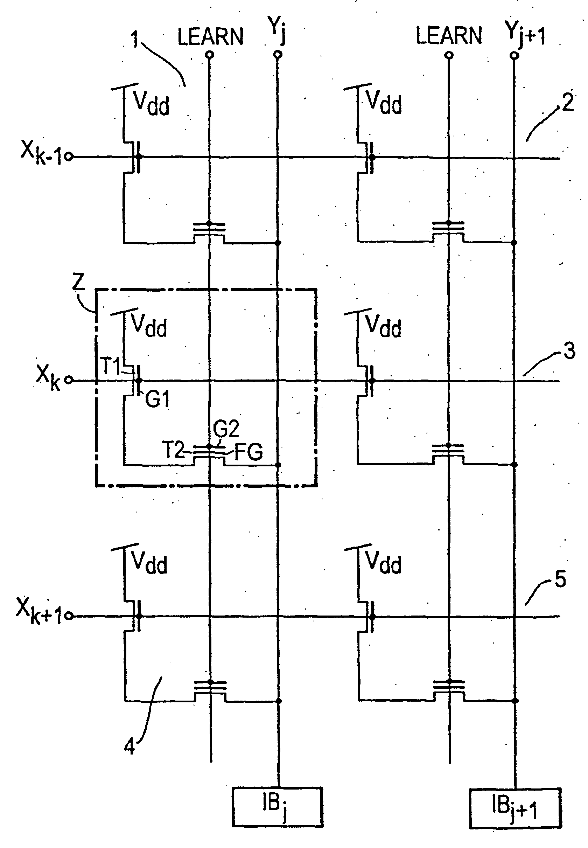

Die Erfindung wird nachfolgend anhand eines in der Zeichnung dargestellten Ausführungsbeispiels näher erläutert.

Durch die Erfindung wird eine funktionale Integration sowohl der Lern- als auch der Speicherfunktion mit Hilfe von zwei in Reihe geschalteten PMOS-Transistoren erreicht.

In der Zeichnung ist beispielhaft ein Ausschnitt mit sechs gleichartigen aufgebauten Zellen 1..5, Z eines Assoziativspeichers dargestellt. Die Zelle Z weist beispielsweise jeweils eine Reihenschaltung aus einem regulären PMOS-Transistor T1 und einen PMOS-Transistor T2 mit Floating-Gate, FG auf, wobei die Reihenschaltung über den Transistor T1 mit der Versorgungsspannung V_{dd} und über den Transistor T2 mit einem Anschluß Yⱼ für das Bitsignal eines Ausgangsvektors Y und einem Eingang eines Strombewerters IBⱼ verbunden ist. Das Gate G1 des Transistors T1 ist mit einem Anschluß Xₖ für das Bitsignal eines Eingangsvektors X beschaltet. Das Gate G2 des Transistors T2 ist mit einem Anschluß LEARN für ein Lernsignal verbunden. Unmittelbare Nachbarzellen 1 und 4 der Speicherzelle Z sind lediglich anstelle des Anschlusses Xₖ mit Anschlüssen Xₖ₋₁ und Xₖ₊₁ für die Nachbar-Bitsignale des Eingangsvektors verbunden und bilden gemeinsam mit Z eine erste Spalte. Die Nachbarspalte besteht aus den Zellen 2, 3 und 5, die nicht mit dem Anschluß Yⱼ, sondern mit dem Anschluß Yⱼ₊₁ für das Nachbar-Bitsignal des Ausgangsvektors und einem weiteren Strombewerter IBⱼ₊₁ verbunden sind.

Eine Spalte besteht aus mehreren Speicherzellen, deren Drainknoten von Transistor T2 jeweils mit dem Anschluß Yⱼ über eine gemeinsame Drain-Leitung verbunden sind. Je nach der Anzahl der in der Lesephase leitenden Speicherzellen fließt in der gemeinsamen Drain-Leitung ein bestimmter Strom. Die an den Drainleitungen angeschlossenen Strombewerter IBⱼ, IBⱼ₊₁, ... ermitteln dann jeweils die Anzahl der in einer Spalte aktivierten Speicherzellen und führen eine Schwellwertentscheidung durch.

### Initialisierung bzw. globales Löschen:

Bevor mit dem eigentlichen Lernvorgang begonnen werden kann, muß die Speichermatrix initialisiert werden, indem in sämtliche Speicherzellen eine 'logische 0' eingeschrieben wird und alle Transitoren mit Floating-Gate zu Normally-Off-Transistoren werden, wobei "Normally -Off" bedeutet, daß bei einer Gate-Source-Spannung von 0V der Transistor sperrt.

Erreicht werden kann dies zum Beispiel durch die Anwendung von UV-Licht auf die hergestellte Schaltung (UV-Löschen) oder aber besser durch Anlegen einer hohen gegenüber dem Substrat (Bulk) positiven Spannung an alle Lerneingänge LEARN, was zu einer positiven Aufladung des Floating-Gates durch Fowler-Nördheim-Tunneln durch das Gate-Oxid führt.

### Assoziatives Speichern:

Beim Assoziativen Speichern gelten beispielsweise die Vereinbarungen, daß bei einer 'logischen 1' ein Spannungspegel von 0 V und bei einer 'logischen 0' ein Spannungspegel von V_{DD} = + 5 V am Anschluß Xₖ anliegt und daß bei einer 'logischen 1' ein negatives Potential, zum Beispiel V_{prog} = - V_{DD} = - 5 V, und bei einer 'logischen 0' ebenfalls ein Spannungspegel von V_{DD} = + 5 V am Anschluß Yⱼ anliegt. Der Lerneingang LEARN wird für alle Speicherzellen konstant mit Masse verbunden.
Die folgende Tabelle zeigt in einer Übersicht die Auswirkungen der verschiedenen Kombinationen der Eingangswerte während der Assoziationsphase.

| X | Y | X | X | (LEARN=0V) |
|---|---|---|---|---|
| '0' | '0' | V_{DD} | V_{DD} | T1 sperrt, kein Stromfluß |
| '0' | '1' | V_{DD} | V_{prog} | T1 sperrt, kein Stromfluß |
| '1' | '0' | 0V | V_{DD} | T1 leitet, aber Y=V_{dd}=5V → kein Stromfluß |
| '1' | '1' | 0V | V_{prog} | T1, T2 leiten, HE-Injektion in FG, FG wird negativ geladen, Uₜ sinkt |

Wie man sieht, erfolgt nur bei Xₖ = Yⱼ = '1' wegen der hohen Drain-Source-Spannung ein Stromfluß und somit eine Heiße-Elektronen-Programmierung des Floating-Gate-PMOS-Transistors durch Injektion heißer Elektronen (HE-Injektion) in das Floating-Gate. Dabei gelangen zusätzliche Elektronen auf das Floating-Gate, die dazu führen, daß sich die Schwellenspannung von T2 in Richtung positiver Werte verändert, bis T2 schließlich ein Normally-On-Transistor ist, wobei "Normally - On" bedeutet, daß der Transistor bei einer Gate-Source-Spannung von 0V leitend ist.

### Lesen (Retrieval):

Bei der Retrievalphase gilt beispielsweise die Vereinbarung, daß am Anschluß Xₖ einer 'logischen 1' ein Spannungspegel von 0V und einer 'logischen 0' ein Pegel von V_{DD} entspricht. Der Anschluß Yⱼ wird hierbei freigeschaltet bzw. kein Signal angelegt und der Drainknoten des Transistors T2 dient hier als Stromausgang der Speicherzelle Z. Der Lerneingang LEARN wird für alle Speicherzellen konstant mit V_{DD} verbunden. Die Reihenschaltung von T1 und T2 wirkt in diesem Fall wie ein UND-Gatter; nur bei X = '1' und Zellenzustand = '1' kommt es zu einem Stromfluß, der von dem am Drainknoten des Transistors T2 über die gemeinsame Drain-Leitung angeschlossenen Strombewerter Ibⱼ, Ibⱼ₊₁, ... detektiert werden kann, denn nur in diesem Fall leiten beide Transistoren gleichzeitig.

## Patentansprüche

1. Assoziativspeicher mit einer Vielzahl von gleichartigen Speicherzellen (Z),
- bei dem eine jeweilige Speicherzelle lediglich aus einer Reihenschaltung eines regulären ersten PMOS-Transistors (T1) und eines zweiten PMOS-Transistors (T2) mit einem Floating-Gate (FG) besteht, wobei ein erster Anschluß des ersten PMOS-Transistors mit einer Versorgungsspannung (V_{dd}) verbunden ist und wobei ein zweiter Anschluß des ersten PMOS-Transistors über den zweiten PMOS-Transistor zum assoziativen Speichern mit einem jeweiligen Anschluß (Yj) für ein Bitsignal eines Ausgangsvektors (Y) und zum Lesen mit einem Strombewerter (Ibⱼ) verbunden ist, und
- bei dem in einer jeweiligen Zelle ein Anschluß (Xₖ) für ein Bitsignal eines jeweiligen Eingangsvektors (X) mit einem Gate (G1) des jeweiligen ersten PMOS-Transistors und ein Anschluß für ein Lernsignal (LEARN) mit einem Gate (G2) des zweiten PMOS-Transistors verbunden sind.

2. Assoziativspeicher nach Anspruch 1,
bei dem die Speicherzellen matrixförmig angeordnet sind, wobei ein jeweiliger Anschluß (Xₖ) für ein Bitsignal des Eingangsvektors mit den Speicherzellen (3) einer gemeinsamen Zeile und ein jeweiliger Anschluß (Yⱼ) für ein Bitsignal des Ausgangsvektors mit Zellen (1, 4) einer gemeinsamen Spalte verbunden ist.

3. Verfahren zum Betrieb eines Assoziativspeichers nach Anspruch 1,
- bei dem ein globales Löschen entweder durch UV-Licht oder durch positive Aufladung des Floating-Gates (FG) mit Hilfe einer gegenüber einem Substrat hohen positiven Spannung am Anschluß für das Lernsignal erfolgt, wobei alle zweiten PMOS-Transistoren (T2) zu Norrnally-Off-Transistoren werden,
- bei dem ein assoziatives Speichern in einer jeweiligen Zelle dadurch erfolgt, daß nur dann solange eine Injektion von heißen Elektronen in das Floating-Gate des jeweiligen zweiten PMOS-Transistors stattfindet bis der zweite PMOS-Transistor zum Normally-On-Transistor wird, wenn die Anschlüsse für das Bitsignal des Eingabevektors und das Bitsignal des Ausgabevektors jeweils mit einem Pegel für logisch 1 beaufschlagt werden, und
- bei dem das Lesen einer jeweiligen Zelle dadurch erfolgt, daß das Lernsignal (LEARN) die Versorgungsspannung (V_{dd}) erhält und durch die jeweilige Reihenschaltung und einen Anschluß für das Bitsignal des Ausgangsvektors nur dann ein Strom fließt, wenn am Anschluß für das jeweilige Bitsignal des Eingangsvektors ein Pegel für eine logische 1 anliegt und der zweite PMOS-Transistor ein Normally-On-Transistor ist, wobei nur genau in diesem Fall beide PMOS-Transistoren leitend sind.

## Claims

1. Associative memory having a multiplicity of memory cells (Z) of identical type,
- in which a respective memory cell merely comprises a series circuit formed by a regular first PMOS transistor (T1) and a second PMOS transistor (T2) with a floating gate (FG), a first terminal of the first PMOS transistor being connected to a supply voltage (V_{dd}), and a second terminal of the first PMOS transistor being connected via the second PMOS transistor to a respective terminal (Yⱼ) for a bit signal of an output vector (Y) for the purpose of associative storage and to a current evaluator (Ibⱼ) for the purpose of reading, and
- in which, in a respective cell, a terminal (Xₖ) for a bit signal of a respective input vector (X) is connected to a gate (G1) of the respective first PMOS transistor and a terminal for a learn signal (LEARN) is connected to a gate (G2) of the second PMOS transistor.

2. Associative memory according to Claim 1,
in which the memory cells are arranged in matrix form, a respective terminal (Xₖ) for a bit signal of the input vector being connected to the memory cells (3) of a common row and a respective terminal (Yⱼ) for a bit signal of the output vector being connected to cells (1, 4) of a common column.

3. Method for operating an associative memory according to Claim 1,
- in which a global erase is effected either by UV light or by positive charging of the floating gate (FG) with the aid of a positive voltage that is high with respect to a substrate at the terminal for the learn signal, all the second PMOS transistors (T2) becoming normally off transistors,
- in which associative storage in a respective cell is effected by virtue of the fact that an injection of hot electrons into the floating gate of the respective second PMOS transistor takes place until the second PMOS transistor becomes the normally on transistor only when the terminals for the bit signal of the input vector and the bit signal of the output vector in each case have a level for logic 1 applied to them, and
- in which a respective cell is read by virtue of the fact that the learn signal (LEARN) receives the supply voltage (V_{dd}) and, through the respective series circuit and a terminal for the bit signal of the output vector, a current flows only when a level for a logic 1 is present at the terminal for the respective bit signal of the input vector and the second PMOS transistor is a normally on transistor, the two PMOS transistors being turned on only precisely in this case.

## Revendications

1. Mémoire associative comportant une multiplicité de cellules de mémoire (Z) de même type,
- dans laquelle une cellule de mémoire respective est constituée simplement d'un montage en série d'un premier transistor PMOS (T1) classique et d'un deuxième transistor PMOS (T2) avec grille flottante (FG), une première borne du premier transistor PMOS étant reliée à une tension d'alimentation (V_{dd}) et une deuxième borne du premier transistor PMOS étant reliée, par l'intermédiaire du deuxième transistor PMOS, d'une part, en vue de la mémorisation associative, à une borne respective (Yⱼ) destinée à un signal binaire d'un vecteur de sortie (Y) et, d'autre part, en vue de la lecture, à un évaluateur de courant (Ibⱼ), et
- dans laquelle, dans une cellule respective, une borne (Xₖ) destinée à un signal binaire d'un vecteur d'entrée respectif (X) est reliée à une grille (G1) du premier transistor PMOS respectif et une borne destinée à un signal d'apprentissage (LEARN) est reliée à une grille (G2) du deuxième transistor PMOS.

2. Mémoire associative selon la revendication 1, dans laquelle les cellules de mémoire sont disposées en forme de matrice, une borne respective (Xₖ) destinée à un signal binaire du vecteur d'entrée est reliée aux cellules de mémoire (3) d'une ligne commune et une borne respective (Yⱼ) destinée à un signal binaire du vecteur de sortie est reliée à des cellules (1, 4) d'une colonne commune.

3. Procédé pour utiliser une mémoire associative selon la revendication 1,
- dans lequel on effectue un effacement global soit par une lumière UV, soit par une charge positive de la grille flottante (FG) à l'aide d'une tension positive élevée par rapport à un substrat et appliquée à la borne destinée au signal d'apprentissage, tous les deuxièmes transistors PMOS (T2) devenant des transistors Normally-Off,
- dans lequel on effectue une mémorisation associative dans une cellule respective en n'injectant des électrons chauds dans la grille flottante du deuxième transistor PMOS respectif jusqu'à ce que le deuxième transistor PMOS devienne un transistor Normally-On que si les bornes destinées au signal binaire du vecteur d'entrée et au signal binaire du vecteur de sortie sont alimentées chacune avec un niveau pour un 1 logique, et
- dans lequel on effectue la lecture d'une cellule respective en faisant en sorte que le signal d'apprentissage (LEARN) reçoive la tension d'alimentation (V_{dd}) et qu'il ne passe un courant par le montage en série respectif et par une borne destinée au signal binaire du vecteur de sortie que s'il existe un niveau pour un 1 logique à la borne destinée au signal binaire respectif du vecteur d'entrée et si le deuxième transistor PMOS est un transistor Normally-On, les deux transistors PMOS n'étant conducteurs que dans ce cas précis.
